# EUROPEAN PATENT APPLICATION

(11) **EP 2 696 128 A1**
(43) Date of publication of application: **12.02.2014**
(21) Application number: 12193949.0
(22) Date of filing: 23.11.2012
(51) Int. Cl.: F21K 99/00, F21V 23/00, F21S 8/04, F21Y 101/02

(54) **Light source device, lighting apparatus**

(30) Priority: 07.08.2012 JP 2012175118
(71) Applicant: Toshiba Lighting & Technology Corporation, Yokosuka-shi Kanagawa 237-8510 (JP)
(72) Inventor: Shibusawa, Soichi, Kanagawa, 237-8510 (JP); Hayashida, Yumiko, Kanagawa, 237-8510 (JP)
(74) Representative: Willquist, Sofia Ellinor

(57) **Abstract**

A device (11) of an embodiment includes a plurality of substrates (21) connected end to end along a predetermined direction. Then, the device of the embodiment includes a plurality of light-emitting elements (45) mounted on each of the substrates and aligned in the predetermined direction, a mounting interval of the light-emitting elements on one of the substrates is different from a mounting interval of the light-emitting elements on another of the substrates.

## Description

### FIELD

Embodiments described herein relate generally to a light source device and a lighting apparatus.

### BACKGROUND

In recent years, a chip on board (COB) system having a plurality of LED (light-emitting diode) chips mounted on a substrate is now in practically use as an LED module.

Examples of the light-emitting module of the COB system include a type used as a light source for a bulb-type LED lamp, which is an intensively-mounted-type formed by forming a flow stopper on the substrate on which the plurality of LED chips are intensively mounted and filling a space formed by the flow stopper with a phosphor resin and letting the phosphor resin to be cured. In the recent years, light-emitting modules including LED chips configured to be arranged in a line at regular intervals on a substrate make their market debut. A straight tube type LED lamp uses a plurality of light-emitting modules connected to each other. In this manner, although the straight tube type LED lamp uses the plurality of light-emitting modules connected to each other, the intervals of the LED chips in the plurality of light-emitting modules to be used are all the same.

Since the intervals of the LED chips in the plurality of light-emitting modules to be used are all the same, in order to obtain a desired luminous flux in the straight tube type LED lamp as described above, the light-emitting modules provided with the LED chips at intervals corresponding to the luminous flux are manufactured. In other words, in the above-described straight tube type LED lamp, manufacturing of the light-emitting module in which the LED chips are provided at the intervals corresponding to the respective luminous fluxes to be obtained is required. Therefore, when manufacturing the above-described straight tube type LED lamp, a large number of types of the light-emitting modules are manufactured. Therefore, manufacturing cost is high.

It is an object of exemplary embodiments is to provide a device, a lighting apparatus and method of assembling a light source for a lighting apparatus which allow reduction of manufacturing cost.

### DESCRIPTION OF THE DRAWINGS

Fig. 1 illustrates a perspective view of a luminaire according to a first embodiment;
Fig. 2 is a cross-sectional view of the luminaire illustrated in Fig. 1;
Fig. 3 is a connection diagram of the luminaire illustrated in Fig. 1;
Fig. 4 is a drawing illustrating an example of a light-emitting module;
Fig. 5 illustrates a cross-sectional view of the light-emitting module taken along the line F7-F7 in Fig. 4;
Fig. 6 illustrates a cross-sectional view of the light-emitting module taken along the line F8-F8 in Fig. 4.
Fig. 7 is a schematic drawing illustrating a configuration of a sealing member provided on the light-emitting module;
Fig. 8 is a drawing illustrating an example of a combination of the light-emitting modules according to a second embodiment;
Fig. 9 is a drawing illustrating an example of the combination of the light-emitting modules according to a third embodiment;
Fig. 10 is a drawing illustrating an example of the combination of the light-emitting modules according to a fourth embodiment;
Fig. 11 is a drawing illustrating an example of the light-emitting modules according to a fifth embodiment; and
Fig. 12 is a drawing illustrating an example of the light-emitting modules according to a sixth embodiment.

### DETAILED DESCRIPTION

Referring now to the drawings, a light source device and a lighting apparatus according to embodiments will be described. In the respective embodiments, configurations having the same function are designated by the same reference numerals and overlapped description will be omitted. The light source device and the lighting apparatus described in the embodiments described below are examples only, and do not limit the invention. The embodiments described below may be combined as needed within the range providing no contradiction.

In the respective embodiments given below, the light source device including a combination of light-emitting modules which provide a predetermined luminous flux will be described. Here, an example of benefits obtained by combining a plurality of the light-emitting modules to configure the light source device will be described instead of the single light-emitting module. For example, the length of each of substrates is reduced by configuring the light source device with the plurality of combined light-emitting modules. Therefore, occurrence of warp of the substrates, and hence occurrence of breaking of a wire provided on the substrate is inhibited. Consequently, by combining the plurality of light-emitting modules to configure the light source device, reduction of the manufacturing cost may be expected.

In a first embodiment to a sixth embodiment described below, the light source device includes a plurality of substrates connected end to end along a predetermined direction. Also, the light source device includes a plurality of light-emitting elements mounted on each of the substrates and aligned in a predetermined direction, a mounting interval of the light-emitting elements on one of the substrates is different from a mounting interval of the light-emitting elements on another of the substrates. When designing the light source device as described above, for example, a small number of types of light-emitting modules different in terms of the interval of the light-emitting elements from one substrate to another may be manufactured and a combination of light-emitting modules which correspond to the luminous flux to be obtained may be used from among the manufactured light-emitting modules.

Therefore, when designing the light source device according to the first embodiment to the sixth embodiment, the types of the light-emitting modules to be manufactured are inhibited. Consequently, according to the light source device of the first embodiment to the sixth embodiment, reduction of the manufacturing cost may be expected. For reference, in the first embodiment to the sixth embodiment, all of the plurality of substrates do not have to be different in terms of the mounting interval, and only at least any one of the substrates have to be formed differently in terms of the mounting intervals from other substrates.

In the first embodiment to the sixth embodiment described below, the mounting intervals of the plurality of light-emitting elements are within a predetermined range. Accordingly, emission of suitable light from the light source device may be expected.

In the first embodiment to the sixth embodiment described below, the mounting intervals of the light-emitting elements are within the mounting interval range from a minimum interval(for example, the shortest length from among the mounting intervals) to an interval that is equal to 1.3 times the minimum interval. Accordingly, emission of suitable light from the light source device may be expected.

In the first embodiment to the sixth embodiment described below, the plurality of substrates have the same lengths and, on each substrate, the light-emitting elements are mounted at regular intervals. Accordingly, in the identical substrate, the intervals of the light-emitting elements are the same, and hence reduction of the manufacturing cost of the substrate may be expected.

In the first embodiment to the sixth embodiment described below, one of the plurality of substrates at one end in the predetermined direction has a non-light-emitting electric component and light-emitting elements mounted on a surface thereof.

In the first embodiment to the sixth embodiment described below, the light source device includes a pipe including a translucent material configured to diffuse light emitted from the plurality of light-emitting elements. In the first embodiment to the sixth embodiment described below, a length of the pipe is substantially equal to a length of a plurality of the substrates connected end-to-end along the predetermined direction, and a luminous flux of the light emitted from the plurality of light-emitting elements diffused by the pipe is a predetermined luminous flux.

In the first embodiment to the sixth embodiment described below, the lighting apparatus includes the light source device. The lighting apparatus includes a lighting device configured to supply power to the light source device and connected to a power supply. When designing the lighting apparatus as described above, for example, light-emitting modules different in terms of the interval of the light-emitting elements from one substrate to another may be manufactured and a combination of light-emitting modules which correspond to the luminous flux to be obtained may be used. Therefore, when designing the lighting apparatus according to the first embodiment to the sixth embodiment, the types of the light-emitting modules to be manufactured will be inhibited. Consequently, according to the lighting apparatus of the first embodiment to the sixth embodiment, reduction of the manufacturing cost may be expected.

Also, in the first embodiment to the sixth embodiment described below, for example, a polycarbonate resin may be used as a resin material that forms the pipe. However, the material that forms the pipe is not limited thereto, and for example, glass may be used. The pipe is preferably formed by mixing a suitable amount of light-diffusing agent in the resin material.

In the first embodiment to the sixth embodiment described below, an LED chip may be exemplified as a semiconductor light-emitting element. However, the semiconductor light-emitting element is not limited thereto, and a semiconductor laser, an EL (Electro Luminescence), for example, may be used as well. When using the LED chip as the light-emitting element, the color of emitted light from the LED chip may be any of red, green, and blue. The LED chips having different colors of emitted light may be combined.

In the second embodiment and the third embodiment described below, the mounting intervals of the light-emitting elements provided on the substrate at the one end are shorter than the mounting intervals of the light-emitting elements provided on the substrates other than the substrate at the one end. Accordingly, in the light source device in the second embodiment and the third embodiment, brightness of light emitted from the light-emitting elements of the substrate located at an end on which the non-light-emitting electric component is mounted is relatively higher than the brightness of the light emitted from other substrates. Therefore, according to the light source device of the second embodiment to the third embodiment described below, lowering of the brightness of the light at an end portion is suppressed.

Also, in the third embodiment described below, the mounting intervals of the light-emitting elements provided on the substrate at another end in the predetermined direction are shorter than the mounting intervals of the light-emitting elements provided on the substrates that are between the substrates at both ends. Accordingly, in the light source device of the third embodiment, the brightness of the light emitted from the light-emitting elements of the substrate located at the end is relatively higher than the brightness of the light emitted from other substrates. Therefore, according to the light source device of the third embodiment, lowering of the brightness of the light at the end portion is suppressed.

In the fourth embodiment described below, the mounting intervals of the light-emitting elements provided on the substrate at the one end are longer than the mounting intervals of the light-emitting elements provided on the substrates other than the substrate at the one end. Accordingly, in the light source device of the fourth embodiment, the brightness of the light emitted from the light-emitting elements of the substrate located at the end on which the non-light-emitting electric component is mounted is relatively lower than the brightness of the light emitted from other substrates. Therefore, the light source device of the fourth embodiment is suitable as a replacement of a fluorescent lamp having a filament, which has dark portions at ends. Therefore, the light source device of the fourth embodiment may be used as a replacement of a fluorescent lamp having the filament, which has the dark portions at the ends.

Also, in the fourth embodiment described below, the mounting intervals of the light-emitting elements provided on the substrate at another end in the predetermined direction are longer than the mounting intervals of the light-emitting elements provided on the substrates that are between the substrates at both ends. In the light source device of the fourth embodiment, the brightness of the light emitted from the light-emitting elements of the substrate located at the end is relatively lower than the brightness of the light emitted from other substrates. Therefore, the light source device of the fourth embodiment is suitable as the replacement of the fluorescent lamp having the filament, which has the dark portions at the ends. Therefore, the light source device of the fourth embodiment may be used as the replacement of the fluorescent lamp having the filament, which has the dark portions at the ends.

In the fifth embodiment described below, the distance of the light-emitting element provided nearest to an end of the substrate to the end of the substrate is one-half of a minimum interval from among the mounting intervals of the light-emitting elements provided on the plurality of substrates. Through setting of the length between the end of the substrate and the light-emitting element provided on the terminal end of the substrate to a predetermined length, manufacture is facilitated. Consequently, according to the light source device of the fifth embodiment, reduction of the manufacturing cost is achieved.

In the sixth embodiment described below, the distance of the light-emitting element provided nearest to an end of the substrate to the end of the substrate is in a range from one-half of a minimum interval to one-half of the minimum interval multiplied by 1.3 from among the mounting intervals of the light-emitting elements provided on the plurality of substrates. In other words, the length described above falls within a range from half the length a which is the shortest from among the mounting intervals on the plurality of substrates to half 1.3 times the shortest interval a. Accordingly, the intervals of the light-emitting element provided at the terminal end of one of the substrates and the light-emitting element provided at the terminal end of the other substrate between the adjacent substrates falls within a range from the length a to the length 1.3a. Accordingly, emission of suitable light from the light source device may be expected.

### [First Embodiment]

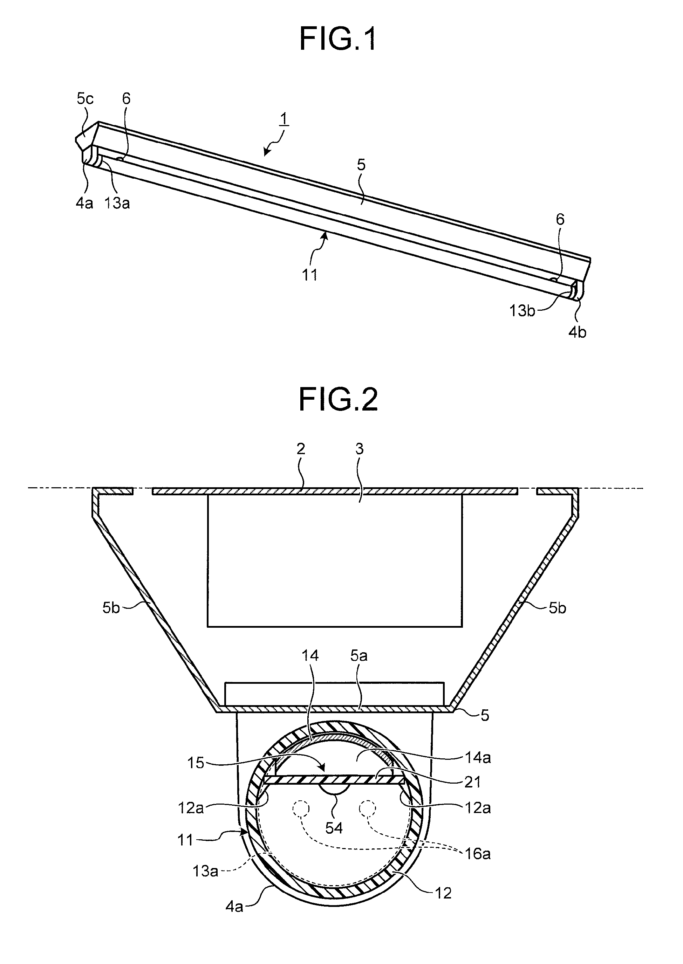

Subsequently, a straight tube type lamp of the first embodiment and the lighting apparatus, for example, a luminaire, provided with the straight tube type lamp will be described with reference to Fig. 1 to Fig. 7.

Fig. 1 illustrates a perspective view of the luminaire according to the first embodiment. Fig. 2 is a cross-sectional view of the luminaire illustrated in Fig. 1. In Fig. 1 and Fig. 2, reference numeral 1 designates a ceiling-type luminaire.

The luminaire 1 includes an apparatus body (luminaire body) 2, a lighting device 3, a pair of first and second sockets 4a and 4b, a reflecting member 5, and a straight tube type lamp 11 which constitutes a light source device.

The apparatus body 2 illustrated in Fig. 2 is formed of, for example, an elongated metallic plate. The apparatus body 2 extends in the direction from the front to the back of the paper of Fig. 2. The apparatus body 2 is fixed to, for example, an indoor ceiling with a plurality of screws, not illustrated.

The lighting device 3 is fixed to an intermediate portion of the apparatus body 2 in the longitudinal direction. The lighting device 3 generates a DC (Direct Current) output upon receipt of a commercial AC (Alternating Current) power supply, and supplies the DC output to the lamp 11, described later.

The apparatus body 2 includes a power supply terminal base, a plurality of member indicating fixtures, and a pair of socket supporting members, not illustrated, mounted thereon. A power supply line of the commercial AC power supply drawn from under the roof is connected to the power supply terminal base. Furthermore, the power supply terminal base is electrically connected to the lighting device 3 via wires in the luminaire, not illustrated.

The sockets 4a and 4b are coupled to the socket supporting member and disposed respectively at both end portions of the apparatus body 2 in the longitudinal direction. The sockets 4a and 4b are of a rotary mounting system. The sockets 4a and 4b are sockets provided on the lamp 11, described later, for example, sockets matching caps 13a and 13b of a G13 type.

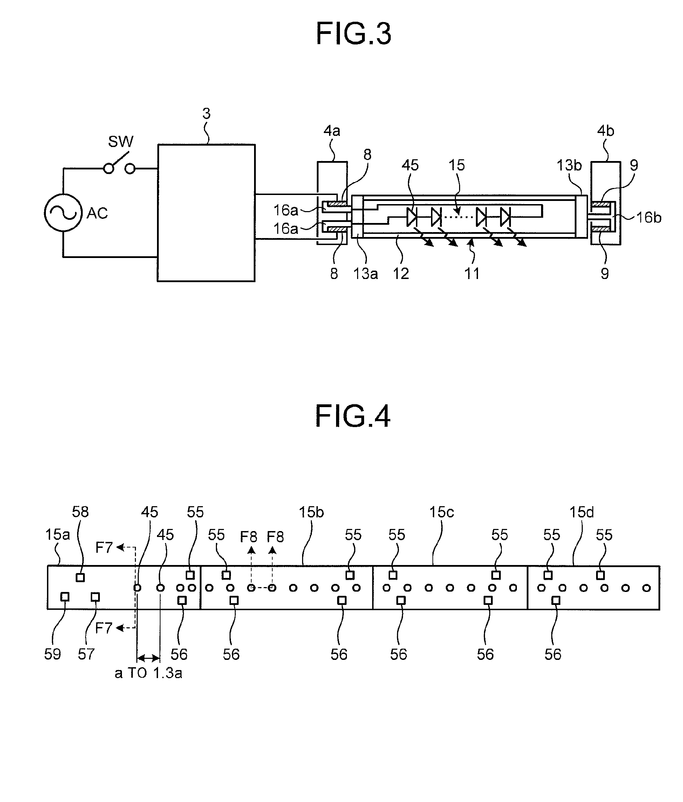

Fig. 3 is a connection diagram of the luminaire illustrated in Fig. 1. As illustrated in Fig. 3, the sockets 4a and 4b have a pair of terminal fixtures 8 and 9 to which lamp pins 16a and 16b, described later, are connected. In order to supply power to the lamp 11 described later, the terminal fixture 8 of the first socket 4a is connected to the lighting device 3 via the wire in the luminaire. For reference, no wire is connected to the terminal fixture 9 of the second socket 4b.

As illustrated in Fig. 2, the reflecting member 5 includes, for example, a bottom plate portion 5a, a side plate portion 5b, and an end plate 5c formed of a metal. The reflecting member 5 is formed into a trough shape opened on top. The bottom plate portion 5a is flat. The side plate portions 5b are bent obliquely upward from both ends of the bottom plate portion 5a in the width direction. The end plates 5c close openings at end surfaces which are formed by ends of the bottom plate portion 5a and the side plate portions 5b in the longitudinal direction. The metallic plates forming the bottom plate portion 5a and the side plate portions 5b are formed of color steel plates having surfaces of a white-based color. Therefore, the surfaces of the bottom plate portion 5a and the side plate portions 5b work as reflecting surfaces. Socket through holes, not illustrated, are formed, respectively, at both end portions of the bottom plate portion 5a in the longitudinal direction.

The reflecting member 5 covers the apparatus body 2 and respective components mounted on the apparatus body 2. Such a state is maintained by removable decoration screws (see Fig. 1) 6. The decoration screws 6 penetrate upward through the bottom plate portion 5a and screwed into member supporting fixtures. The decoration screws 6 may be rotated manually without using a tool. The sockets 4a and 4b project downward of the bottom plate portion 5a through socket through holes.

The luminaire 1 is not limited to a configuration in which only one piece of the lamp 11 is supported described below. For example, the luminaire 1 may be provided with two pairs of the sockets and configured to support two of the lamps 11.

The lamp 11 demountably supported by the sockets 4a and 4b will be described below with reference to Fig. 2 to Fig. 7.

The lamp 11 has the same dimensions and an outer diameter as existing fluorescent lamps. The lamp 11 includes a pipe 12, the first cap 13a and the second cap 13b mounted at both ends of the pipe 12, a beam 14, and a plurality of, for example, four light-emitting modules 15. When discriminating the four light-emitting modules 15, suffixes of a to d are attached to "15" in illustration and described.

The pipe 12 is formed of a translucent resin material into, for example, an elongated shape. The polycarbonate resin mixed with a light diffusing material as the resin material which forms the pipe 12 may be preferably used. The diffusion transmittance of the pipe 12 is preferably 90% to 95%. As illustrated in Fig. 2, the pipe 12 includes a pair of projections 12a on an inner surface of an upper portion in a state in use.

The first cap 13a is mounted on one end portion of the pipe 12 in the longitudinal direction. The second cap 13b is mounted on the other end portion of the pipe 12 in the longitudinal direction. The first and second caps 13a and 13b are demountably connected to the sockets 4a and 4b. The lamp 11 supported by the sockets 4a and 4b by the connection described above is arranged right below the bottom plate portion 5a of the reflecting member 5. Part of light emitted from the lamp 11 to the outside enters the side plate portions 5b of the reflecting member 5.

As illustrated in Fig. 3, the first cap 13a includes two of the lamp pins 16a projecting to the outside. The lamp pins 16a are electrically insulated from each other. In addition, distal end portions of the two lamp pins 16a each are bent almost at a right angle so as to extend away from each other and form an L-shape. As illustrated in Fig. 3, the second cap 13b includes one lamp pin 16b projecting to the outside thereof. The lamp pin 16b is provided at a column-shaped shaft portion and at a distal end portion of the column-shaped shaft portion, has a distal end portion having an ellipse shape or an oval shape in front view (not illustrated), and has a T-shape in side view.

Through the connection of the lamp pins 16a of the first cap 13a to the terminal fixture 8 of the socket 4a and the connection of the lamp pin 16b of the second cap 13b to the terminal fixture 9 of the socket 4b, the lamp 11 is mechanically supported by the sockets 4a and 4b. In this supported state, power distribution to the lamp 11 is enabled by the terminal fixture 8 in the socket 4a and the lamp pins 16a of the first cap 13a in contact with the terminal fixture 8.

As illustrated in Fig. 2, the beam 14 is accommodated in the pipe 12. The beam 14 is a bar member superior in mechanical strength, and is formed of aluminum alloy for reduction of the weight, for example. Both ends of the beam 14 in the longitudinal direction are coupled to the first cap 13a and the second cap 13b in the state of electrical insulation. The beam 14 includes a plurality of (illustrated in Fig. 2 is only one) substrate supporting portions 14a formed into a rib shape, for example.

Fig. 4 is a drawing illustrating an example of the light-emitting module. As illustrated in Fig. 4, all of the four light-emitting modules 15a to 15d are formed into an elongated rectangular shape and are arranged in a straight row. The length of the light-emitting module row is substantially the same as the entire length of the beam 14. The respective light-emitting modules 15a to 15d are fixed to the beam 14 with screws, not illustrated, screwed therein.

Therefore, the light-emitting modules 15a to 15d are accommodated in the pipe 12 together with the beam 14. In this supported state, the both end portions of the respective light-emitting modules 15a to 15d in the width direction are placed on the projections 12a of the pipe 12. Accordingly, the respective light-emitting modules 15a to 15d are disposed substantially horizontally on the upper side of the maximum width portion in the pipe 12.

Here, an example of the method for determining combinations of the light-emitting modules 15a to 15d will be described. For example, when the shortest distance from among the mounting intervals of the adjacent light-emitting elements is defined to "a", even though the intervals of the light-emitting elements vary within a range from the distance a to the distance 1.3a, which is 1.3 times the distance a, light from the lamp having such the light-emitting elements is not constrained for human. Therefore, a plurality of types of the light-emitting modules each having light-emitting elements 45 arranged at regular intervals within a substrate 21, which are different in terms of the intervals of the light-emitting elements 45 from each other within the range from the distance a to the distance 1.3a, are manufactured. The number of types of the light-emitting modules manufactured in this manner may be minimized. Then, through determination of the four light-emitting modules of combinations corresponding to the luminous fluxes to be obtained from among the manufactured light-emitting modules, the combinations of the light-emitting modules 15a to 15d may be determined. In this manner, when designing the lamp 11 of the first embodiment, the types of the light-emitting modules to be manufactured are inhibited. Consequently, according to the first embodiment, reduction of the manufacturing cost may be expected.

As described above, in the first embodiment, the combination of the light-emitting modules 15a to 15d corresponding to the luminous flux to be obtained is determined from among a plurality of types of the light-emitting modules each having the light-emitting elements 45 arranged at intervals different from one module to another within the range from the distance a to the distance 1.3a. Therefore, as illustrated in Fig. 4, the intervals of the light-emitting elements 45 of the respective light-emitting modules 15a to 15d are different from one light-emitting module 15a to another 15d within the range from the distance a to the distance 1.3a. In the determined combination of the light-emitting modules 15a to 15d, the intervals of all the light-emitting elements 45 may be the same by chance. However, such a case is very rare, and the intervals of at least part of the light-emitting elements 45 are different from that of other light-emitting elements 45 in many cases.

As the distance a, a distance from 5 mm to 9 mm inclusive may be employed.

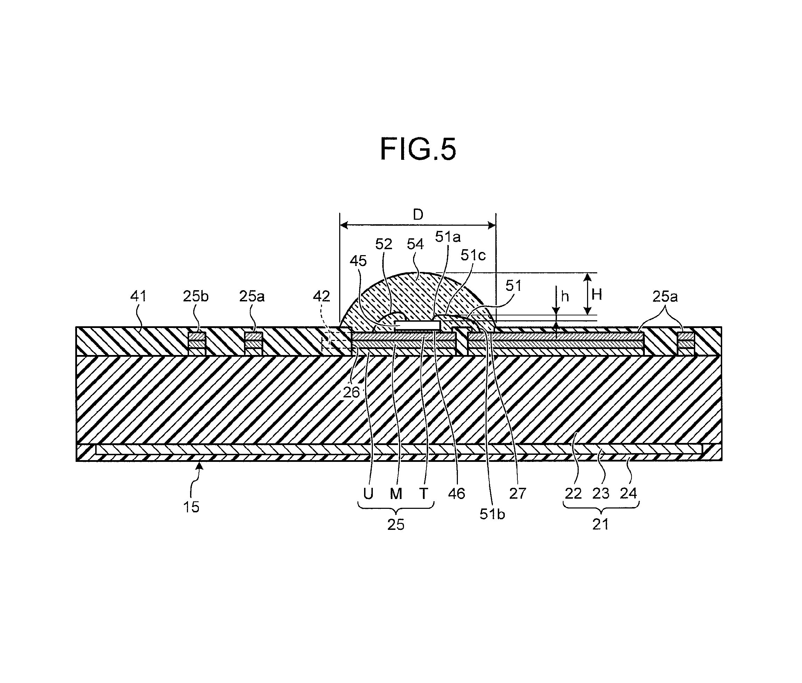

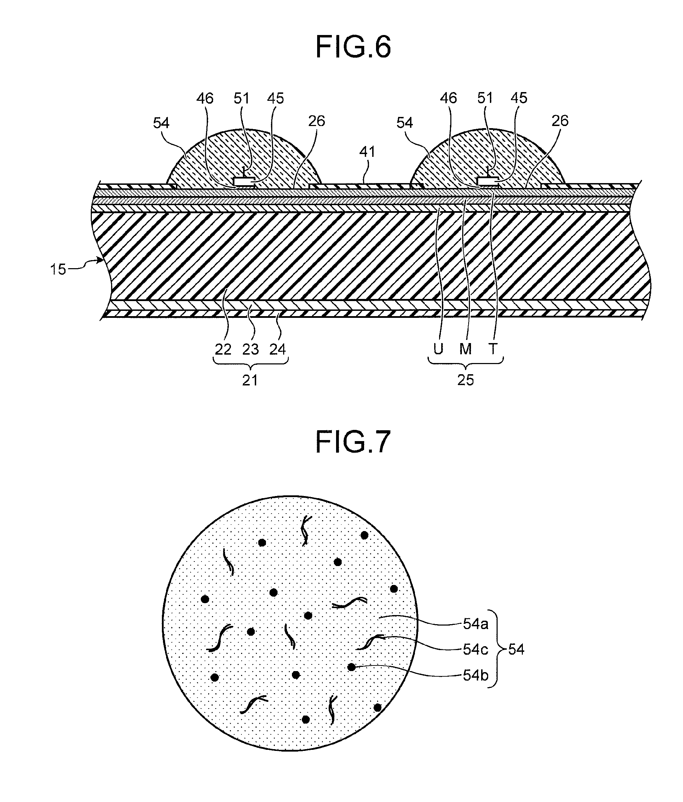

Fig. 5 illustrates a cross-sectional view of the light-emitting module taken along the line F7-F7 in Fig. 4. Fig. 6 is a cross-sectional view of the light-emitting module taken along the line F8-F8 in Fig. 4. As illustrated in Fig. 5 and Fig. 6, the light-emitting module 15 includes the substrate 21, a wiring pattern 25, a protecting member 41, a plurality of the light-emitting elements 45, a first wire 51, a second wire 52, and a sealing member 54. The light-emitting module 15 includes various electric components 55 to 59.

The substrate 21 includes a base 22, a metallic foil 23, and a cover layer 24.

The base 22 is a flat plate formed of a resin, for example, a glass epoxy resin. The substrate (FR-4) of the glass epoxy resin is low in terms of thermal conductivity and is relatively inexpensive. The base 22 may be formed of a glass composite substrate (CEM-3) or other synthetic resin materials.

As illustrated in Fig. 5 and Fig. 6, the metallic foil 23 is laminated on a back surface of the substrate 21. The metallic foil 23 is formed, for example, of a copper foil. The cover layer 24 is laminated over the back surface of the peripheral portion of the base 22 and the metallic foil 23. The cover layer 24 is formed of an insulating material, for example, a synthetic-resin-made resist layer. The substrate 21 is inhibited from warping and is reinforced by the metallic foil 23 and the cover layer 24 laminated on the back surface thereof. In the first embodiment, the length of the substrate 21 is prescribed to a predetermined length so that the length of the combined four substrates 21 becomes the length which can be accommodated in the pipe 12.

The wiring pattern 25 is formed on a surface of the base 22 (a surface of the substrate 21) in a three-layer structure. A first layer U is formed of copper plated on the surface of the base 22. A second layer M is plated on the first layer U and is formed of nickel. A third layer T is plated on the second layer M and is formed of silver.

Therefore, a surface of the wiring pattern 25 is formed of silver. The silver third layer T works as a reflecting surface, and the total beam reflectance thereof is 90% or higher.

As the protecting member 41, for example, a white resist layer which mainly contains an electrically insulative synthetic resin, may preferably be used. The white resist layer functions as a reflecting layer having a high light reflectance. The protecting member 41 is formed on the substrate 21 so as to cover most part of the wiring pattern 25.

Respective mounting pads 26 and respective conductive connection portions 27 are formed on a portion where the third layer T is exposed without being covered with the protecting member 41 at the stage of the formation of the protecting member 41 on the substrate 21. The respective mounting pads 26 are arranged in the longitudinal direction of the substrate 21. The respective conductive connection portions 27 are disposed in the vicinity of the respective mounting pads 26 in pairs with the respective mounting pads 26. Therefore, the respective conductive connection portions 27 are arranged in the longitudinal direction of the substrate 21 at the same disposition pitch as that of the respective mounting pads 26.

The plurality of light-emitting elements 45 are composed of LED-bearing chips. As the bearing chips, for example, LED-bearing chips emitting blue light are used. The LED-bearing chips each are formed by providing a light-emitting layer over one surface of a sapphire element substrate, and have a rectangular shape in plan view.

The plurality of light-emitting elements 45 are each fixed at the other surface of the element substrate opposite the one surface described above to the mounting pads 26 as the reflecting surface with an adhesive agent 46. The light-emitting elements 45 form light-emitting element rows arranged in the longitudinal direction of the substrate 21 (the direction in which the center axial line extends).

The bonded places of the light-emitting elements 45 are preferably the centers of the mounting pads 26. Accordingly, light emitted from the light-emitting elements 45 and entering the mounting pads 26 may be reflected by the reflecting surface area around the light-emitting elements 45.

In this case, the closer to the light-emitting elements 45, the stronger the strength of the light entering the mounting pads 26 becomes. The reflecting surface area may reflect the strong light.

The light emitted from the light-emitting elements 45 composed of the LED bear chips is achieved by causing an electric current to flow through an p-n joint of a semiconductor in the forward direction. Therefore, the light-emitting elements 45 are solid elements configured to convert electric energy directly to light. The light-emitting elements 45 emitting light in such a light-emitting principle has a higher energy saving effect than that of an incandescent lamp configured to cause a filament to be heated to high temperatures by energization to cause visible light to be radiated by thermal radiation from the filament.

The adhesive agent 46 preferably has heat resistance in terms of obtaining the durability of bonding, and has translucency to allow reflection even right under the light-emitting element 45. A silicone-resin-based adhesive agent may be used as the above-described adhesive agent 46.

The first wire 51 and the second wire 52 are formed of metallic thin wires, such as gold thin wires. The first wire 51 and the second wire 52 are wired using a bonding machine.

As illustrated in Fig. 5, the first wire 51 is provided so as to electrically connect the light-emitting element 45 and the conductive connection portion 27 of a first wiring pattern 25a. In this case, one end portion 51a of the first wire 51 is connected to an electrode of the light-emitting element 45 by first bonding. The other end portion 51b of the first wire 51 is connected to the conductive connection portion 27 by second bonding.

The one end portion 51a of the first wire 51 protrudes in the direction away from the light-emitting element 45 and in the direction of the thickness of the light-emitting element 45. The conductive connection portion 27 is closer to the substrate 21 than the above-described electrode and other electrodes of the light-emitting element 45 with respect to the direction of the thickness of the light-emitting element 45. The other end portion 51b of the first wire 51 is connected obliquely with respect to the conductive connection portion 27.

An intermediate portion 51c of the first wire 51 is a portion occupying a portion between the one end portion 51a and the other end portion 51b. The intermediate portion 51c is formed so as to be bent from the one end portion 51a and parallel to the light-emitting element 45 as illustrated in Fig. 5. A projecting height h of the intermediate portion 51c with respect to the light-emitting element 45 is prescribed from 75 µm to 125 µm inclusive, preferably, from 60 µm to 100 µm inclusive. Accordingly, the wire-bonded first wire 51 is wired so as to hold the height with respect to the light-emitting element 45 to be low.

As described above, the intermediate portion 51c and the other end portion 51b of the wired first wire 51 extend in the direction orthogonal to the direction in which the light-emitting elements 45 form the row. Such wiring is realized by the above-described arrangement of the light-emitting elements 45 with respect to the mounting pad 26. With such wiring, the length of the first wire 51 may be reduced. Therefore, in the plan view, the cost of the first wire 51 is reduced with respect to the case where the first wire 51 is wired obliquely with respect to the light-emitting elements.

The second wire 52 is provided so as to connect the light-emitting element 45 and the mounting pad 26 formed of part of the first wiring pattern 25a by wire-bonding. In this case, one end portion of the second wire 52 is connected to the other electrode described above of the light-emitting element 45 by the first bonding. The other end portion of the second wire 52 is connected to the mounting pads 26 by the second bonding.

Therefore, the plurality of light-emitting elements 45 mounted on the substrates 21 of the respective light-emitting modules 15 are electrically connected. The plurality of light-emitting element 45 groups mounted on the respective substrates are also electrically connected therebetween. The plurality of light-emitting elements 45 emit light when power is supplied from the lighting device 3.

Fig. 7 is a schematic drawing illustrating a configuration of a sealing member provided on the light-emitting module. As schematically illustrated in Fig. 7, the sealing member 54 is formed by mixing suitable amounts of phosphor 54b and filler 54c respectively to a resin 54a as a main component.

A thermal curing resin having translucency may be used as the resin 54a. A resin-based silicone resin is preferably used as the resin 54a, for example. The resin-based silicone resin has a three-dimensionally cross-linked composition. Therefore, the resin-based silicone resin is harder than silicone rubber having translucency.

The phosphor 54b is excited by light emitted by the light-emitting elements 45 and radiates light in a color different from the color of light emitted by the light-emitting elements 45. In the first embodiment, since the light-emitting elements 45 emit blue light, yellow phosphor emitting yellow-based light by being excited in a complementary relationship with the blue light is used. Accordingly, white light may be emitted as output light from the lamp 11 as a light-emitting device.

The sealing member 54 is formed on the substrate 21 by embedding and sealing the mounting pad 26, the conductive connection portion 27, the light-emitting element 45, the first wire 51, and the second wire 52 respectively therein. The sealing members 54 are dropped at the light-emitting elements 45 in an uncured state, and then are formed by being cured through a heating process. A dispenser is used for dripping (potting) of the sealing member 54.

The cured sealing members 54 are arranged on the substrate 21 at a predetermined interval in the longitudinal direction of the substrate 21, and are disposed while forming a sealing member row so as to conform with the row of the light-emitting elements 45. The cured sealing member 54 is formed into a dome shape or a shape like Mt. Fuji.

A diameter D (see Fig. 5) of the sealing member 54 is prescribed to be 1.0 to 1.4 times a pad diameter D1 and, in the first embodiment, the diameter D is 4.0 mm to 5.0 mm. Accordingly, part of the mounting pads 26 is inhibited from protruding from the sealing member 54. In addition, the amount of the sealing member 54 to be used for mounting pads 26 is not too much, so that an adequate amount of the sealing member 54 may be used while maintaining an aspect ratio, described later. A frame or the like which surrounds the light-emitting element 45 or the like in order to prescribe a height H and the diameter D of the sealing member 54 does not exist. Therefore, the diameter D and the height H of the sealing member 54 is configured to be controlled by the amount of dripping, the hardness, and the time until being cured of the sealing member 54.

The height H of the sealing member 54 with reference to the light-emitting element 45 is 1.0 mm or higher. In order to secure the height H of 1.0 mm or higher, the aspect ratio of the sealing member 54 is set to be 0.22 to 1.00. Here, the aspect ratio of the sealing member 54 is the ratio of the diameter D of the sealing member 54 with respect to the height H of the sealing member 54 with reference to the light-emitting element 45 (H/D).

In addition, the ratio of the orthogonal diameters of the sealing member 54 is 0.55 to 1.00. Here, the ratio of the orthogonal diameters indicates the ratio of diameters X and Y orthogonal to each other on a bottom surface of the sealing member 54 bonded to the substrate 21. The diameter X is a diameter of the bottom surface of the sealing member 54 drawn arbitrary through the center of the light-emitting element 45. The diameter Y is a diameter of the bottom surface of the sealing member 54 drawn orthogonally to the diameter X.

Electric components 55 illustrated in Fig. 4 are capacitors. An electric component 56 is a connector. An electric component 57 is a rectification diode, that is, a rectification circuit. An electric component 58 is a resistance. An electric component 59 is an input connector. The rectification circuit 57 as the rectification circuit rectifies power supplied from the lighting device 3. The electric components 57 and 58 generate heat in association with energization.

The electric components 55 formed of capacitors are mounted on the respective four light-emitting modules 15. The capacitors are connected in parallel to the respective light-emitting element group.

The electric components 55 disposed in this manner function as a bypass element causing noise superimposed on the wiring patterns 25 of the respective light-emitting modules 15 to bypass and flow to the light-emitting element group. Accordingly, the superimposition of the noise on the light-emitting element group is inhibited. Therefore, the dark lighting of the lamp 11 due to the noise flowing to the light-emitting element 45 in a state in which the power supply is turned OFF may be inhibited by a switch SW illustrated in Fig. 3.

The electric components 56 formed of connectors are mounted only at one end portion on the light-emitting modules 15a and 15d disposed at both end portions of the light-emitting module row in the longitudinal direction. The electric components 56 are mounted respectively on both end portions thereof in the longitudinal direction of the light-emitting modules 15b and 15c disposed between the light-emitting modules 15a and 15d. The electric components 56 are connected to a terminal portion of the first wiring pattern 25a and a terminal portion of the second wiring pattern 25b.

In addition, the electric components 56 of the adjacent light-emitting modules 15 are connected by electric cables, not illustrated, extending therebetween. The respective light-emitting modules 15 are electrically connected in series through such connection.

The electric component 59 formed of an input connector is connected to the wiring pattern 25a of the light-emitting module 15a. The wires, not illustrated, connected to the electric component 59 are connected respectively to the lamp pins 16a of the first cap 13a disposed at a position nearer to the electric component 59.

By turning ON the switch SW in a state in which the both ends of the straight tube type lamp 11 having the configuration described above are supported by the sockets 4a and 4b of the luminaire 1, power is supplied from the first socket 4a to the first cap 13a of the lamp 11 via the lighting device 3. With the power distribution, the respective light-emitting elements 45 emit light at a time, and in association, white light emitted from the sealing member 54 is diffused in the pipe 12 and radiated to the outside through the pipe. Accordingly, a lower space of the lamp 11 is illuminated. In addition, part of the white light radiated from the pipe 12 is reflected by the side plate portions 5b of the reflecting member 5 and illuminates a space above the lamp 11 or the like.

The lamp 11 of the first embodiment includes a plurality of the substrates 21 configured to be continuously connected in a predetermined direction. Then, the lamp 11 of the first embodiment includes the plurality of light-emitting elements 45 configured to be arranged in the predetermined direction on each of the plurality of substrates 21 so that a mounting interval on at least one of the substrate 21 is different from the mounting interval on other substrates. When designing the lamp 11 as described above, for example, a small number of types of the light-emitting modules 15 having the light-emitting elements 45 provided at different intervals from one substrate 21 to another are manufactured in advance. Then, the light-emitting modules 15a to 15d of combinations corresponding to the luminous fluxes to be obtained may be used from among the manufactured light-emitting modules 15. Accordingly, when designing the lamp 11 of the first embodiment, the types of the light-emitting modules 15 to be manufactured will be inhibited. Therefore, according to the lamp 11 of the first embodiment, reduction of the manufacturing cost may be expected.

The plurality of light-emitting elements 45 of the first embodiment are provided on the substrate 21 at intervals within a predetermined range. Accordingly, emission of suitable light from the lamp 11 of the first embodiment may be expected.

The plurality of light-emitting elements 45 of the first embodiment are provided on the substrate 21 at intervals of a range from the length a to the length 1.3a when the reference length (for example, the shortest length from among the mounting intervals) is set to "a". Accordingly, emission of suitable light from the lamp 11 of the first embodiment may be expected.

The light-emitting elements 45 of the first embodiment are provided at regular intervals on the identical substrate 21, and the interval of the light-emitting elements 45 provided on at least one of the plurality of substrates 21 is different from that on other substrates 21. Accordingly, in the identical substrate 21, the intervals of the light-emitting elements 45 are the same, and hence reduction of the cost of manufacture of the substrate 21 may be expected.

In the first embodiment, one of the plurality of substrates 21 configured to be connected in a predetermined direction located at both ends is a substrate 21 on which the non-light-emitting electric component 57 is mounted on a surface where the light-emitting elements 45 are provided.

In the lamp 11 of the first embodiment, the pipe 12 configured to be formed so as to include a translucent material configured to diffuse light emitted from the plurality of light-emitting elements 45 is provided. In the lamp 11 of the first embodiment, a length in a predetermined direction of the plurality of substrates 21 configured to be connected in a predetermined direction is a length which can be accommodated in the pipe 12, and a luminous flux of the light emitted from the plurality of light-emitting elements 45 diffused by the pipe 12 is a predetermined luminous flux.

The luminaire 1 as the lighting apparatus of the first embodiment includes the lamp 11 and the lighting device 3 connected to the power supply and configured to supply power to the lamp 11. When designing the lamp 11 of the luminaire 1 described above, for example, a small number of types of the light-emitting modules 15 having the light-emitting elements 45 provided at different intervals from one substrate 21 to another are manufactured in advance. Then, the light-emitting modules 15a to 15d of combinations corresponding to the luminous fluxes to be obtained may be used from among the manufactured light-emitting modules 15. Accordingly, when designing the lamp 11 of the luminaire 1 of the first embodiment, the types of the light-emitting modules 15 to be manufactured is inhibited. Therefore, according to the luminaire 1 of the first embodiment, reduction of the manufacturing cost may be expected.

### [Second Embodiment]

Subsequently, the second embodiment will be described. The second embodiment is different from the first embodiment in the combination of the light-emitting modules 15a to 15d corresponding to the luminous fluxes to be obtained from among the manufactured light-emitting modules 15. Other points are the same as the first embodiment, and hence the description will be omitted.

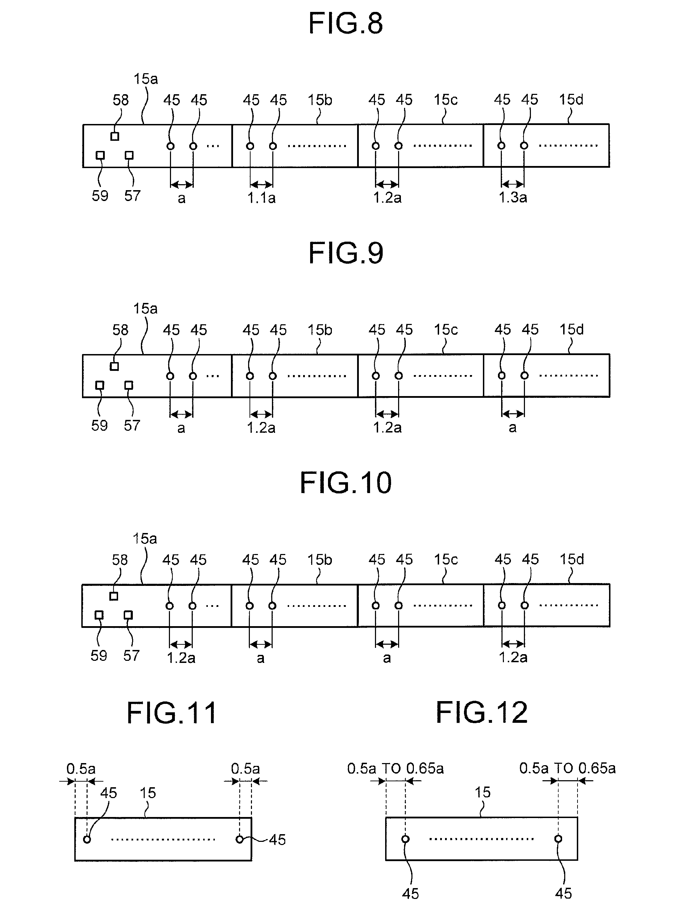

Fig. 8 is a drawing illustrating an example of a combination of the light-emitting modules according to the second embodiment. In the example illustrated in Fig. 8, a light-emitting module having the light-emitting elements 45 arranged at intervals of the distance a is determined and used as the light-emitting module 15a. In the example illustrated in Fig. 8, a light-emitting module having the light-emitting elements 45 arranged at intervals of a distance 1.1a is determined and used as the light-emitting module 15b. In the example illustrated in Fig. 8, a light-emitting module having the light-emitting elements 45 arranged in a distance 1.2a is determined and used as the light-emitting module 15c. In the example illustrated in Fig. 8, a light-emitting module having the light-emitting elements 45 arranged at intervals of a distance 1.3a is determined and used as the light emitting module 15d. In the example illustrate in Fig. 8, the electric components 55 and 56 are omitted.

In the lamp 11 of the second embodiment, the intervals of the light-emitting elements 45 provided on the substrate 21 on which the rectification circuit 57 is mounted are shorter than those of the light-emitting elements 45 provided on the substrate 21 other than the substrate 21 where the rectification circuit 57 is mounted. Accordingly, in the lamp 11 of the second embodiment, brightness of light emitted from the light-emitting elements 45 of the substrate 21 located at an end on which the rectification circuit 57 is mounted is relatively higher than the brightness of light emitted from other substrates 21. Therefore, according to the lamp 11 of the second embodiment, lowering of brightness of the light at an end portion is suppressed.

### [Third Embodiment]

Subsequently, the third embodiment will be described. The third embodiment is different from the first embodiment and the second embodiment in the combination of the light-emitting modules 15a to 15d corresponding to the luminous fluxes to be obtained from among the manufactured light-emitting modules 15. Other points are the same as the first embodiment and the second embodiment, and hence the description will be omitted.

Fig. 9 is a drawing illustrating an example of a combination of the light-emitting modules according to the third embodiment. In the example illustrated in Fig. 9, a light-emitting module having the light-emitting elements 45 arranged at intervals of the distance a is determined and used as the light-emitting module 15a. In the example illustrated in Fig. 9, a light-emitting module having the light-emitting elements 45 arranged at intervals of a distance 1.2a is determined and used as the light-emitting module 15b. In the example illustrated in Fig. 9, a light-emitting module having the light-emitting elements 45 arranged at intervals of the distance 1.2a is determined and used as the light-emitting module 15c. In the example illustrated in Fig. 9, a light-emitting module having the light-emitting elements 45 arranged at intervals of the distance a is determined and used as the light-emitting module 15d. In the example illustrated in Fig. 9, the electric components 55 and 56 are omitted.

In the lamp 11 of the third embodiment, the intervals of the light-emitting elements 45 provided on the substrate 21 on which the rectification circuit 57 is mounted are shorter than those of the light-emitting elements 45 provided on the substrates 21 of the light-emitting modules 15b and 15c. Accordingly, in the lamp 11 of the third embodiment, the brightness of the light emitted from the light-emitting elements 45 of the substrate 21 located at the end on which the rectification circuit 57 is mounted is relatively higher than the brightness of the light emitted from the substrates 21 of the light-emitting modules 15b and 15c. Therefore, according to the lamp 11 of the third embodiment, lowering of brightness of the light at the end portion is suppressed.

In the third embodiment, the intervals of the light-emitting elements 45 provided on the substrate 21 of the light-emitting module 15d at the end are shorter than those of the light-emitting elements 45 provided on the substrates 21 of the light-emitting modules 15b and 15c. Accordingly, in the lamp 11 of the third embodiment, the brightness of the light emitted from the light-emitting elements 45 of the substrate 21 of the light-emitting module 15d at the end is relatively higher than the brightness of the light emitted from the substrates 21 of the light-emitting modules 15b and 15c. Therefore, according to the lamp 11 of the third embodiment, lowering of brightness of the light at the end portion is suppressed.

### [Fourth Embodiment]

Subsequently, the fourth embodiment will be described. The fourth embodiment is different from the first embodiment to the third embodiment in the combination of the light-emitting modules 15a to 15d corresponding to the luminous fluxes to be obtained from among the manufactured light-emitting modules 15. Other points are the same as the first embodiment to the third embodiment, and hence the description will be omitted.

Fig. 10 is a drawing illustrating an example of a combination of the light-emitting modules according to the fourth embodiment. In the example illustrated in Fig. 10, a light-emitting module having the light-emitting elements 45 arranged at intervals of the distance 1.2a is determined and used as the light-emitting module 15a. In the example illustrated in Fig. 10, a light-emitting module having the light-emitting elements 45 arranged at intervals of the distance a is determined and used as the light-emitting module 15b. In the example illustrated in Fig. 10, a light-emitting module having the light-emitting elements 45 arranged at intervals of the distance a is determined and used as the light-emitting module 15c. In the example illustrated in Fig. 10, a light-emitting module having the light-emitting elements 45 arranged at intervals of the distance 1.2a is determined and used as the light-emitting module 15d. In the example illustrated in Fig. 10, the electric components 55 and 56 are omitted.

In the lamp 11 of the fourth embodiment, the intervals of the light-emitting elements 45 provided on the substrate 21 on which the rectification circuit 57 is mounted are longer than those of the light-emitting elements 45 provided on the substrates 21 of the light-emitting modules 15b and 15c. Accordingly, in the lamp 11 of the fourth embodiment, the brightness of the light emitted from the light-emitting elements 45 of the substrate 21 located at the end on which the rectification circuit 57 is mounted is relatively lower than the brightness of the light emitted from the substrates 21 of the light-emitting modules 15b and 15c. Therefore, the lamp 11 according to the fourth embodiment is suitable as the replacement of the fluorescent lamp having the filament, which has the dark portions at the ends. Therefore, the lamp 11 of the fourth embodiment may be used as the replacement of the fluorescent lamp having the filament, which has the dark portions at the ends.

In the fourth embodiment, the intervals of the light-emitting elements 45 provided on the substrate 21 of the light-emitting module 15d at the end are longer than those of the light-emitting elements 45 provided on the substrates 21 of the light-emitting modules 15b and 15c. Accordingly, in the lamp 11 of the fourth embodiment, the brightness of the light emitted from the light-emitting elements 45 of the substrate 21 of the light-emitting module 15d at the end is relatively lower than the brightness of the light emitted from the substrates 21 of the light-emitting modules 15b and 15c. Therefore, the lamp 11 of the fourth embodiment is suitable as the replacement of the fluorescent lamp having the filament, which has the dark portions at the ends. Therefore, the lamp 11 of the fourth embodiment may be used as the replacement of the fluorescent lamp having the filament, which has the dark portions at the ends.

### [Fifth Embodiment]

Subsequently, the fifth embodiment will be described. In the first embodiment to the fourth embodiment described above, the fifth embodiment is **characterized in that** the distances between the light-emitting elements 45 provided at the terminal ends of the substrates 21 of the light-emitting modules 15 and the ends of the substrates 21 are fixed. Other points are the same as the first embodiment to the fourth embodiment, and hence the description will be omitted.

Fig. 11 is a drawing illustrating an example of the light-emitting modules according to the fifth embodiment. As illustrated in Fig. 11, the length between the light-emitting element 45 provided at the terminal ends of the substrates of the light-emitting modules 15 of the fifth embodiment and the ends of the substrates are fixed to a predetermined length 0.5a. Through fixation of the length between the ends of the substrates and the light-emitting elements 45 provided on the terminal ends of the substrates to the predetermined length 0.5a, manufacture of the light-emitting module 15 is facilitated. Therefore, according to the lamp 11 of the fifth embodiment, reduction of the manufacturing cost is achieved. The predetermined length is not limited to 0.5a, values from the length 0.5a to the length 0.65a inclusive may be employed.

### [Sixth Embodiment]

Subsequently, the sixth embodiment will be described. In the first embodiment to the fourth embodiment described above, the sixth embodiment is **characterized in that** the distances between the light-emitting elements 45 provided at the terminal ends of the substrates 21 of the light-emitting modules 15 and the ends of the substrates 21 are variable within a range from 0.5a to 0.65a. Other points are the same as the first embodiment to the fourth embodiment, and hence the description will be omitted.

Fig. 12 is a drawing illustrating an example of the light-emitting modules according to the sixth embodiment. As illustrated in Fig. 12, the length between the light-emitting element 45 provided at the terminal ends of the substrates of the light-emitting modules 15 of the sixth embodiment and the ends of the substrates are variable in a range from the length 0.5a to the length 0.65a. Accordingly, the interval between the light-emitting element 45 provided at the terminal end of one of the substrates 21 and the light-emitting element 45 provided at the terminal end of the other substrate 21 between the adjacent substrates 21 falls within a range from the length a to the length 1.3a. Therefore, emission of suitable light from the lamp 11 of the sixth embodiment may be expected.

The respective embodiments have been described as above. The lamp 11 of the respective embodiments from the second embodiment to the sixth embodiment described above includes the plurality of substrates 21 connected continuously in a predetermined direction in the same manner as the first embodiment. The lamp 11 of the respective embodiments from the second embodiment to the sixth embodiment includes the plurality of light-emitting elements 45 configured to be arranged in a line in a predetermined direction on each of the plurality of substrates 21 so that a mounting interval on at least a substrate is different from the mounting interval on other substrates. When designing such the lamp 11, the combination of the light-emitting modules 15a to 15d corresponding to the luminous fluxes to be obtained may be used from among the manufactured small number of types of light-emitting modules 15. Therefore, when designing the lamp 11 of the respective embodiments from the second embodiment to the sixth embodiment, the types of the light-emitting modules 15 to be manufactured will be inhibited. Therefore, according to the lamp 11 of the respective embodiments from the second embodiment to the sixth embodiment, reduction of the manufacturing cost may be expected as in the first embodiment.

The plurality of light-emitting elements 45 of the respective embodiments from the second embodiment to the sixth embodiment are provided on the substrate 21 at intervals within a predetermined range in the same manner as in the first embodiment. Accordingly, emission of suitable light from the lamp 11 of the respective embodiment from the second embodiment to the sixth embodiment may be expected.

The plurality of light-emitting elements 45 of the respective embodiments from the second embodiment to the sixth embodiment are provided on the substrate 21 at intervals of a length from the length a to the length 1.3a when the reference length (for example, the shortest length from among the mounting intervals) is set to "a" in the same manner as in the first embodiment. Accordingly, emission of suitable light from the lamp 11 of the respective embodiments from the second embodiment to the sixth embodiment may be expected.

The light-emitting elements 45 of the respective embodiments from the second embodiment to the sixth embodiment are characterized as follows in the same manner as in the first embodiment. In other words, the light-emitting elements 45 as described above are provided at regular intervals on the identical substrate 21, and the interval of the light-emitting elements 45 provided on at least one of the plurality of substrates 21 is different from that of other substrates 21. Accordingly, in the identical substrate 21, the intervals of the light-emitting elements 45 are the same, and hence reduction of the cost of manufacture of the substrate 21 may be expected.

In the respective embodiments from the second embodiment to the sixth embodiment, one of the plurality of substrates 21 configured to be connected in the predetermined direction located at the both ends is the substrate 21 on which the non-light-emitting electric component 57 is mounted on the surface where the light-emitting elements 45 are provided in the same manner as in the first embodiment.

In the lamp 11 of the respective embodiments from the second embodiment to the sixth embodiment, the pipe 12 configured to be formed so as to include the translucent material configured to diffuse light emitted from the plurality of light-emitting elements 45 is provided in the same manner as in the first embodiment. In the lamp 11, the predetermined length of the plurality of substrates 21 configured to be connected in the predetermined direction is the length which can be accommodated in the pipe 12, and the luminous flux of the light emitted from the plurality of light-emitting elements 45 diffused by the pipe 12 is the predetermined luminous flux.

The luminaire 1 as the lighting apparatus of the the respective embodiments from the second embodiment to the sixth embodiment includes the lamp 11, and the lighting device 3 configured to supply power to the lamp 11 connected to the power supply in the same manner as the first embodiment. When designing such the lamp 11 of the luminaire 1, for example, the combination of the light-emitting modules 15a to 15d corresponding to the luminous fluxes to be obtained may be used from among the manufactured small number of types of light-emitting modules 15. Therefore, when designing the lamp 11 of the luminaire 1 of the respective embodiments from the second embodiment to the sixth embodiment, the types of the light-emitting modules 15 to be manufactured will be inhibited. Consequently, according to the luminaire 1 of the respective embodiments from the second embodiment to the sixth embodiment, reduction of the manufacturing cost may be expected.

While certain embodiments have been described, these embodiments have been presented by way of example only, and are not intended to limit the scope of the inventions. Indeed, the novel embodiments described herein may be embodied in a variety of other forms; furthermore, various omissions, substitutions and changes in the form of the embodiments described herein may be made without departing from the spirit of the inventions. The accompanying claims and their equivalents are intended to cover such forms or modifications as would fall within the scope and spirit of the inventions.

For example, in the embodiments described above, the case where the intervals of the light-emitting elements 45 in the substrate 21 are fixed in the identical substrate 21 has been described. However, the intervals of the light-emitting elements 45 may vary within a range from a to 1.3a in the identical substrate 21.

In the above-described embodiments, the lengths of the substrates 21 of the light-emitting modules 15 used for the lamp 11 in the longitudinal direction are preferably the same. When the lengths of the substrates 21 are the same, further reduction of the manufacturing cost may be expected. It is also possible to provide two lengths of the substrates 21 of the light-emitting modules 15 used for the lamp 11 in the longitudinal direction, one for the substrate 21 on which the electric component 57 of the rectification circuit is mounted, and one for other substrates 21 on which the electric component 57 of the rectification circuit is not mounted.

## Claims

1. A device (11) comprising:
a plurality of substrates (21) connected end to end along a predetermined direction; and
a plurality of light-emitting elements (45) mounted on each of the substrates and aligned in the predetermined direction, a mounting interval of the light-emitting elements on one of the substrates is different from a mounting interval of the light-emitting elements on another of the substrates.

2. The device according to Claim 1, wherein mounting intervals of the plurality of light-emitting elements (45) are within a predetermined range.

3. The device according to Claim 2, wherein the mounting intervals range from a minimum interval to an interval that is equal to 1.3 times the minimum interval.

4. The device according to Claim 1, wherein the plurality of substrates (21) have the same lengths and, on each substrate, the plurality of light-emitting elements (45) are mounted at regular intervals.

5. The device according to Claim 1, wherein one of the plurality of substrates at one end in the predetermined direction has a non-light-emitting electric component (57) and light-emitting elements mounted on a surface thereof.

6. The device according to Claim 5, wherein the mounting intervals of the light-emitting elements provided on the substrate at the one end are shorter than the mounting intervals of the light-emitting elements provided on the substrates other than the substrate at the one end.

7. The device according to Claim 5, wherein the mounting intervals of the light-emitting elements provided on the substrate at the one end are longer than the mounting intervals of the light-emitting elements provided on the substrates other than the substrate at the one end.

8. The device according to Claim 5, wherein the mounting intervals of the light-emitting elements provided on the substrate at another end in the predetermined direction are shorter than the mounting intervals of the light-emitting elements provided on the substrates that are between the substrates at both ends.

9. The device according to Claim 5, wherein the mounting intervals of the light-emitting elements provided on the substrate at another end in the predetermined direction are longer than the mounting intervals of the light-emitting elements provided on the substrates that are between the substrates at both ends.

10. The device according to Claim 1, wherein the distance of the light-emitting element provided nearest to an end of the substrate to the end of the substrate is one-half of a minimum interval from among the mounting intervals of the light-emitting elements provided on the plurality of substrates.

11. The device according to Claim 1, wherein the distance of the light-emitting element provided nearest to an end of the substrate to the end of the substrate is in a range from one-half of a minimum interval to one-half of the minimum interval multiplied by 1.3 from among the mounting intervals of the light-emitting elements provided on the plurality of substrates.

12. The device according to Claim 1 further comprising:
a pipe (12) including a translucent material configured to diffuse light emitted from the plurality of light-emitting elements.

13. The device according to claim 12, wherein a length of the pipe is substantially equal to a length of a plurality of the substrates connected end-to-end along the predetermined direction.

14. A lighting apparatus (1) comprising:
a light source (11) according to any one of Claims 1 to 13; and
a lighting device (3) configured to supply power to the light source and connected to a power supply.

15. A method of assembling a light source (11) for a lighting apparatus (1), the light source including a plurality of substrates connected end-to-end along a predetermined direction, said method comprising:
selecting a first substrate (21) having a plurality of light-emitting elements (45) mounted thereon at a first regular interval and in alignment along the predetermined direction;
selecting a second substrate (21) having a plurality of light-emitting elements (45) mounted thereon at a second regular interval and in alignment along the predetermined direction; and
mounting the plurality of substrates including the first and second substrates adjacent to each other on a common beam,
wherein the first and second regular intervals are different.
